# EUROPÄISCHE PATENTSCHRIFT

(11) **EP 0 808 481 B1**
(45) Veröffentlichungstag und Bekanntmachung des Hinweises auf die Patenterteilung: **02.06.1999**
(21) Anmeldenummer: 96900861.4
(22) Anmeldetag: 29.01.1996
(51) Int. Cl.: G03F 7/20, G03F 7/09, G03F 7/26

(54) **VERFAHREN ZUR PHOTOLITHOGRAPHISCHEN STRUKTURERZEUGUNG**
PHOTOLITHOGRAPHIC STRUCTURE GENERATION PROCESS
PROCEDE POUR LA PRODUCTION PHOTOLITHOGRAPHIQUE DE STRUCTURES

(30) Priorität: 10.02.1995 DE 19504477
(43) Veröffentlichungstag der Anmeldung: 26.11.1997
(73) Patentinhaber: SIEMENS AKTIENGESELLSCHAFT, 80333 München (DE)
(72) Erfinder: LEUSCHNER, Rainer, D-91085 Weisendorf (DE); GÜNTHER, Ewald, D-91074 Herzogenaurach (DE); HAMMERSCHMIDT, Albert, D-91056 Erlangen (DE); FALK, Gertrud, D-91056 Erlangen (DE)
(86) Internationale Anmeldenummer: DE9600116
(87) Internationale Veröffentlichungsnummer: WO9624887

(56) Entgegenhaltungen:
- DATABASE INSPEC INSTITUTE OF ELECTRICAL ENGINEERS, STEVENAGE, GB Inspec No. 3846536, PANG S W ET AL: "Plasma-deposited amorphous carbon films as planarization layers" XP002004022 & 34TH INTERNATIONAL SYMPOSIUM ON ELECTRON, ION AND PHOTON BEAMS, SAN ANTONIO, TX, USA, 29 MAY-1 JUNE 1990, Bd. 8, Nr. 6, ISSN 0734-211X, JOURNAL OF VACUUM SCIENCE & TECHNOLOGY B (MICROELECTRONICS PROCESSING AND PHENOMENA), NOV.-DEC. 1990, USA, Seiten 1980-1984,
- DATABASE INSPEC INSTITUTE OF ELECTRICAL ENGINEERS, STEVENAGE, GB Inspec No. 4098477, DOBISZ E A ET AL: "Scanning tunneling microscope lithography: a solution to electron scattering" XP002004023 & 35TH INTERNATIONAL SYMPOSIUM ON ELECTRON, ION AND PHOTON BEAMS, SEATTLE, WA, USA, 28-31 MAY 1991, Bd. 9, Nr. 6, ISSN 0734-211X, JOURNAL OF VACUUM SCIENCE & TECHNOLOGY B (MICROELECTRONICS PROCESSING AND PHENOMENA), NOV.-DEC. 1991, USA, Seiten 3024-3027,
- DATABASE INSPEC INSTITUTE OF ELECTRICAL ENGINEERS, STEVENAGE, GB Inspec No. 3846506, FUJINO T ET AL: "The surface silylating process using chemical amplification resist for electron beam lithography" XP002004024 & 34TH INTERNATIONAL SYMPOSIUM ON ELECTRON, ION AND PHOTON BEAMS, SAN ANTONIO, TX, USA, 29 MAY-1 JUNE 1990, Bd. 8, Nr. 6, ISSN 0734-211X, JOURNAL OF VACUUM SCIENCE & TECHNOLOGY B (MICROELECTRONICS PROCESSING AND PHENOMENA), NOV.-DEC. 1990, USA, Seiten 1808-1813,
- DATABASE INSPEC INSTITUTE OF ELECTRICAL ENGINEERS, STEVENAGE, GB Inspec No. 4876302, IRMSCHER M ET AL: "Comparative evaluation of chemically amplified resists for electron-beam top surface imaging use" XP000497201 & 38TH INTERNATIONAL SYMPOSIUM ON ELECTRON ION AND PHOTON BEAMS (EIPB'94), NEW ORLEANS, LA, USA, 31 MAY-3 JUNE 1994, Bd. 12, Nr. 6, ISSN 0734-211X, JOURNAL OF VACUUM SCIENCE & TECHNOLOGY B (MICROELECTRONICS AND NANOMETER STRUCTURES), NOV.-DEC. 1994, USA, Seiten 3925-3929,

## Beschreibung

Die Erfindung betrifft ein Verfahren zur photolithographischen Erzeugung von Strukturen im Bereich unterhalb von 200 nm.

In der Halbleitertechnologie und in der Mikroelektronik werden die Strukturabmessungen immer kleiner. Bei der Speicherproduktion werden heutzutage Strukturen mit einer Breite von weniger als 400 nm erzeugt; hierbei wird die optische Lithographie in Verbindung mit der Maskentechnik eingesetzt. Aufgrund von Beugungseffekten ist bei der optischen Lithographie bei ca. 150 nm eine Grenze zu erwarten. Für neuartige Anwendungen, wie Ein-Elektron-Transistoren oder molekularelektronische Bauelemente, sind aber Strukturen mit noch geringeren Abmessungen erforderlich. Dies gilt im Falle sehr hochfrequenter Schaltkreise auch für die konventionelle Elektronik.

Möglichkeiten zur Erzeugung derartig kleiner Strukturen bietet die Röntgenlithographie, mit der - aufgrund der kürzeren Wellenlänge - auch Abmessungen unter 100 nm abgebildet werden können. Hierbei ergeben sich aber Probleme bei den erforderlichen Masken und bei der Positionierung. Dies ist bei der Elektronen- und Ionenstrahllithographie nicht der Fall. Da dies direkt-schreibende Methoden sind, benötigen sie nämlich keine Masken. Bei der Elektronen- und Ionenstrahllithographie können mit hochenergetischen Teilchen Strukturen bis hinab zu 10 nm erzeugt werden. Hierzu sind aber aufwendige Vakuumanlagen und Strahl führungssysteme erforderlich. Außerdem können bei empfindlichen Bauelementen Probleme durch Strahlenschäden im Substrat auftreten, weil die hochenergetischen Teilchen durch die für Ätzprozesse erforderlichen Resistschichten hindurchdringen können.

Eine neuartige Möglichkeit der hochauflösenden Strukturierung bieten die Rasternahfeldtechniken, insbesondere die Rastertunnelmikroskopie (STM = Scanning Tunneling Microscopy) und die Rasterkraftmikroskopie (SFM = Scanning Force Microscopy). Diese Techniken sind zwar, was die Schreibgeschwindigkeit anbetrifft, prinzipiell langsamer als Elektronenstrahlschreiber, es besteht aber die Möglichkeit, parallel mit einer Reihe von Nahfeldsonden zu arbeiten. Für erste Entwicklungen dürfte außerdem die Schreibgeschwindigkeit und damit die Zeit nicht ausschlaggebend sein, weil sich der große Vorteil ergibt, daß aufwendige Vakuumsysteme entfallen können.

Bei den Rasternahfeldtechniken wird eine feine, spitze Sonde in konstant gehaltenem Abstand über die Probenoberfläche bewegt, und auf diese Weise werden Topographieunterschiede kompensiert. Zur Abstandsregulierung dienen dabei Wechselwirkungen zwischen der Probenoberfläche und der Sondenspitze. Wenn diese Techniken, die in der Regel nur zum Abtasten von Oberflächentopographien eingesetzt werden, als strukturierende Methoden verwendet werden sollen, dann wird durch eine von außen angelegte Spannung - je nach dem Vorzeichen der Spannung - ein Stromfluß von der Sondenspitze in die Probe oder umgekehrt erzeugt, der eine chemische oder physikalische Änderung der Probenoberfläche bewirkt. Da der Abstand zwischen Sondenspitze und Probenoberfläche extrem klein ist, können Stöße zwischen den austretenden Elektronen und Luftmolekülen vernachlässigt werden, und deshalb ist bei den Rasternahfeldtechniken eine Elektronenbestrahlung der Probenoberfläche nicht nur im Hochvakuum möglich, sondern auch bei Normaldruck. Dies ist ein wesentlicher Vorteil gegenüber dem eigentlichen Elektronenstrahlschreiben, bei dem - für die Stoßfreiheit der Elektronen in der Beschleunigungsstrecke (1 bis 50 kV) - ein Hochvakuum Voraussetzung ist, was einen erheblichen Kostenaufwand bedeutet.

Bei den Rasternahfeldtechniken können die emittierten Elektronen nicht auf eine hohe kinetische Energie beschleunigt werden. Wird nämlich die an der Sonde anliegende Spannung zu hoch gewählt (etwa > 80 V), dann kann es zu einer unkontrollierten Schädigung von Probe und Sonde kommen. Für die Elektronenbestrahlung mit Rasternahfeldsonden kommen somit nur Elektronen mit einer Energie etwa bis zu 80 eV in Frage. Diese Energie reicht nun zwar aus, um in üblichen elektronenstrahl empfindlichen Resistmaterialien chemische Veränderungen zu initiieren, sie ist aber nicht groß genug, damit die Elektronen dielektrische Resistschichten mit einer Dicke von mehr als einigen 10 nm durchdringen. Der Vorteil, daß Strahlenschäden im Substrat ausgeschlossen sind, wird deshalb bislang durch den Nachteil überwogen, daß nur extrem dünne Resistschichten verwendet werden können.

In der Mikroelektronik sind nun aber Plasmabearbeitungstechniken üblich, beispielsweise reaktives Ionenätzen (RIE = Reactive Ion Etching), die strukturierbare, ätzresistente Masken in Form von Resists mit einer Schichtdicke > 100 nm voraussetzen, und zwar je nach der Ätztiefe der zu erzeugenden Strukturen. Beim Einsatz von Rasternahfeldtechniken muß deshalb entweder auf eine Substratätzung durch Plasmaätzprozesse verzichtet werden, wobei das Aspektverhältnis der erzeugten Strukturen (Höhe:Breite) dann aber auf Werte < 1 begrenzt ist, oder die Ätzprozesse müssen so durchgeführt werden, daß die Ätztiefe die Resistdicke nicht übersteigt (siehe dazu: P. Avouris (ed.) "Atomic and Nanometer-Scale Modification of Materials: Fundamentals and Applications", Kluwer Academic Publishers, 1993, Seiten 139 bis 148). Eine andere Möglichkeit besteht in der Verwendung von Metallhalogeniden, insbesondere Calciumfluorid (CaF₂), welche bereits in dünner Schicht die für Substratätzprozesse erforderliche Ätzstabilität aufweisen (siehe dazu: "Journal of Vacuum Science & Technology B", Vol. 5 (1987), Seiten 430 bis 433). Die lithographischen Eigenschaften derartiger anorganischer Materialien sind aber sehr schlecht, insbesondere ist die zur Strukturierung benötigte Dosis sehr hoch; sie beträgt beispielsweise für einen 20 nm dicken CaF₂-Resist 1 C/cm². Dadurch wird aber die Schreibgeschwindigkeit und damit auch der Durchsatz begrenzt.

Aufgabe der Erfindung ist es, ein Verfahren anzugeben, das die Erzeugung von Sub-200-nm-Strukturen mit hohem Aspektverhältnis mittels niederenergetischer Elektronen bei Normaldruck erlaubt, gleichzeitig aber die Strukturierung dicker Resistschichten (> 100 nm) ermöglicht.

Dies wird erfindungsgemäß dadurch erreicht, daß auf ein Substrat eine Schicht aus amorphem wasserstoffhaltigem Kohlenstoff mit einem optischen Bandabstand < 1 eV oder aus gesputtertem amorphem Kohlenstoff als Bottomresist aufgebracht wird, wobei die Schichtdicke ≤ 500 nm beträgt, daß der Bottomresist mit einer Schicht eines elektronenstrahlempfindlichen, siliciumhaltigen oder silylierbaren Photoresists mit einer Schichtdicke ≤ 50 nm als Topresist versehen wird, daß der Topresist mittels Rastertunnelmikroskopie oder Rasterkraftmikroskopie mit Elektronen einer Energie von ≤ 80 eV strukturiert wird, und daß die Struktur durch Ätzen mit einem anisotropen Sauerstoffplasma in den Bottomresist und nachfolgend durch Plasmaätzen in das Substrat übertragen wird.

Das Verfahren nach der Erfindung beinhaltet eine Reihe wesentlicher Maßnahmen. So wird ein Zweilagenresistsystem mit einem Topresist (obere Schicht) und einem Bottomresist (untere Schicht) eingesetzt. Der Topresist ist dabei ein dünner elektronenstrahlempfindlicher Photoresist (Schichtdicke ≤ 50 nm). Dieser Photoresist, der als Positiv- oder Negativresist vorliegen kann, ist siliciumhaltig oder silylierbar. Ein silylierbarer Resist bietet den Vorteil, daß durch eine chemische Nachbehandlung die Schichtdicke erhöht und die Ätzstabilität im Sauerstoffplasma gesteigert werden kann. Der Bottomresist ist eine relativ dicke Schicht (≤ 500 nm) aus amorphem wasserstoffhaltigem Kohlenstoff (a-C:H), der einen optischen Bandabstand < 1 eV besitzt, oder aus gesputtertem amorphem Kohlenstoff (a-C). Ein derartiges Resistmaterial hat folgende Eigenschaften:
- es besitzt eine ausreichende elektrische Leitfähigkeit
- es kann als geschlossener, homogener dünner Film aufgebracht werden,
- es enthält keine ionischen Verunreinigungen,
- es wird durch das Lösungsmittel für den Topresist nicht angegriffen,
- es ist in einem Sauerstoffplasma leicht und rückstandsfrei ätzbar,
- es weist eine hohe Stabilität bei Ätzprozessen mit halogenhaltigen Plasmen auf.

Schichten aus a-C:H mit den vorstehend genannten Eigenschaften können durch Abscheidung aus einem Kohlenwasserstoffplasma erzeugt werden, und zwar nach einem sogenannten PECVD-Verfahren (Plasma Enhanced Chemical Vapour Deposition). Die Verfahrensparameter, d.h. Gasart, Gasdruck und die - durch die Leistung und die Reaktorgeometrie bedingte - Self-bias-Spannung, werden dabei so gewählt, daß dieses Material einen genügend kleinen optischen Bandabstand (< 1 eV) bzw. eine ausreichende elektrische Leitfähigkeit (≥ 10⁻⁵ Ω⁻¹·cm⁻¹) besitzt. Dadurch wird erreicht, daß niederenergetische Elektronen über die untere Resistschicht abgeführt werden können.

Geeignete a-C-Schichten können durch Sputtern aus einem Graphittarget in einer konventionellen Sputteranlage erhalten werden; dabei werden Sputterparameter eingehalten, welche zu glatten, haftfesten Schichten führen. Gegebenenfalls muß das Substrat, auf dem die Abscheidung erfolgt, mittels eines geeigneten Reinigungsprozesses (Argon- oder Sauerstoffplasma) vorbehandelt werden.

Beim Verfahren nach der Erfindung wird der Topresist - mittels eines Rastertunnelmikroskops oder eines Rasterkraftmikroskops - mit niederenergetischen Elektronen (Spannung ≤ 80 V) bestrahlt und strukturiert. Die Strahlendosis beträgt dabei vorteilhaft 1 bis 50 mC/cm², vorzugsweise 10 bis 30 mC/cm². Die erzeugte Struktur wird dann mit Hilfe eines anisotropen Sauerstoffplasmas (O₂-RIE) in den Bottomresist übertragen, d.h. in die a-C:H- bzw. a-C-Schicht, und nachfolgend durch Plasmaätzen in das Substrat. Die Strukturübertragung in das Substrat erfolgt im allgemeinen mittels eines Halogenplasmas, wie Tetrafluormethan (CF₄); weitere geeignete Halogenplasmen sind beispielsweise Chlor (Cl₂), Bortrichlorid (BCl₃) und Schwefelhexafluorid (SF₆). Bei Substraten wie Polyimid dient zur Strukturübertragung ein Sauerstoffplasma.

Die vorstehend genannten Maßnahmen bewirken, daß mit einem sehr dünnen Photoresist große Ätztiefen im Substrat erreicht werden können. Die Ätztiefe im Substrat ist dabei abhängig von der Ätzselektivität des Substrats im Vergleich zur Bottomresistschicht (aus a-C:H bzw. a-C). Da a-C:H-Schichten unter Streß stehen können, werden sie prinzipiell nur auf Materialien abgeschieden, bei denen eine gute Haftung gegeben ist. Dabei ist eine Abscheidung auf den in der Halbleitertechnik gängigsten Substratmaterialien, wie monokristallines Silicium, polykristallines Silicium, SiO₂, Quarz, Si₃N₄, SiC, Aluminium und Polyimid, problemlos möglich; bei Galliumarsenid ist die abscheidbare Schichtdicke im allgemeinen auf Werte unter 200 nm begrenzt. Für die Ätzselektivität (Substrat:a-C:H) in einem durch Radiofrequenz angeregten Plasma ergeben sich beispielsweise folgende Werte: polykristallines Silicium 6:1 (Cl₂; 800 W/3,7 µbar), SiO₂ 20:1 (CF₄; 700 W/ 5 µbar), Aluminium 5:1 (SiCl₄+Cl₂+N₂; 360 W/0,16 mbar), Polyimid 2:1 (O₂; 900 W/3 µbar). Auf Kupfer und Wolfram kann a-C:H nicht direkt abgeschieden werden, in diesen Fällen findet deshalb eine Zwischenschicht aus Aluminium Verwendung.

Schichten aus a-C weisen einen geringeren Streß auf und können deshalb auf allen gängigen Substratmaterialien abgeschieden werden, auch auf Kupfer und Wolfram. Diese Schichten weisen eine vergleichbare Ätzstabilität wie a-C:H auf. Schichten aus a-C sind allerdings für sichtbares Licht undurchlässig, so daß das Auffinden von Justiermarken erschwert sein kann und optische Schichtdickenmessungen unter Umständen nicht möglich sind.

Als elektronenstrahlempfindliche Topresists werden bevorzugt solche Materialien eingesetzt, welche zur Bestrahlung nur eine geringe Dosis benötigen. Dies ist insbesondere bei Resists der Fall, die nach dem Prinzip der sogenannten chemischen Verstärkung arbeiten (chemically amplified resists). Mit derartigen Resists, die auch bei der Elektronenstrahllithographie eingesetzt werden (bei 30 keV benötigte Dosis: < 10 µc/cm²), läßt sich die Schreibzeit minimieren.

Vorteilhaft werden Topresists eingesetzt, die silyliert werden können, was nach der Strukturierung erfolgt. Ein derartiger Resist besitzt funktionelle Gruppen, die in der Lage sind, mit siliciumhaltigen Agenzien zu reagieren. Derartige Gruppen sind insbesondere Anhydridgruppen, die beispielsweise mit Aminopropylsiloxanen umgesetzt werden können, und Hydroxylgruppen, die beispielsweise mit Silazanen umgesetzt werden können. Zur chemischen Nachbehandlung der Resists werden dabei Lösungen von funktionellen Siliciumverbindungen der genannten Art eingesetzt, wie sie für die entsprechenden Resistmaterialien bekannt sind (siehe dazu beispielsweise: "Polymer Engineering and Science", Vol. 32 (1992), Seiten 1558 bis 1564, sowie "Journal of Vacuum Science & Technology B", Vol. 10 (1992), Seiten 2610 bis 2614). Im übrigen können - je nach der Prozeßführung des Resists - Gräben (positive Bilder) oder Linien (negative Bilder) erzeugt werden.

Anhand folgender Beispiele wird die Erfindung noch näher erläutert.

### Beispiel 1

Ein Siliciumwafer wird in einer mit Methan gefüllten PECVD-Anlage (paralleler Plattenreaktor, 3-Zoll-Kathode mit 13,56-MHz-Sender, Anode sechsmal größer) mit amorphem wasserstoffhaltigem Kohlenstoff - mit einem optischen Bandabstand von 0,85 eV - beschichtet (Schichtdicke: 450 nm); Abscheideparameter: -900 V Self-bias-Spannung, 0,1 mbar Methandruck, 7 min Abscheidezeit. Auf diese Schicht wird durch Spin-coating eine 45 nm dicke Schicht eines elektronenstrahlempfindlichen Resists aufgebracht und bei 120°C für 60 s auf einer Heizplatte getrocknet; dem Resist liegt ein Basispolymer mit Anhydrid- und tert.-Butylestergruppen zugrunde (siehe dazu EP-OS 0 494 383). Die obere Schicht wird dann mittels eines Rastertunnelmikroskops (STM-Gerät) "belichtet", indem die mit -50 V beaufschlagte Sondenspitze mit einer Geschwindigkeit von 1 µm/s die Probe abrastert und so Linien "schreibt" (Strom: 10 pA). Danach wird der Wafer bei 120°C für 120 s auf einer Heizplatte ausgeheizt und anschließend 60 s lang in einer wäßrigen Entwicklerlösung aus Tetramethylammoniumhydroxid (1,19 %) und 1-Phenylethylamin (0,25 %) entwickelt, wobei 150 nm breite Gräben entsprechend dem Scan-Muster entstehen (positives Bild); der Dunkelabtrag bei der Entwicklung beträgt 5 nm. Nachfolgend wird der Wafer 60 s lang mit einer Silylierungslösung behandelt, die aus einer 4 %igen Lösung von Diaminopropyl-dimethylsiloxan-oligomer in einer Mischung aus 2-Propanol und Ethanol (Verhältnis 2:1) besteht. Dabei wächst die Schichtdicke des Resists um 45 nm auf insgesamt 85 nm an, und die Grabenbreite nimmt von 150 nm auf 80 nm ab. Die auf diese Weise erzeugten Strukturen werden mittels einer Plasmaätzanlage (Typ MIE 720, Fa. MRC) bei einer RF-Leistung von 900 W (45 V Self-bias-Spannung) und einem Sauerstofffluß von 30 sccm (3 µbar) in die amorphe wasserstoffhaltige Kohlenstoffschicht übertragen. Die Ätzzeit beträgt dabei 84 s (inklusive 50 % Überätzung), wobei die Dicke der Photoresistschicht auf 15 nm abnimmt und die Grabenbreite der Strukturen auf 100 nm zunimmt. Das Aspektverhältnis der Strukturen in der Kohlenstoffschicht beträgt somit 4,5. Die Resiststruktur wird dann mittels eines CF₄-Plasmas in den Siliciumwafer übertragen, wobei sich die maximal mögliche Ätztiefe aus der Resistschichtdicke und der Ätzselektivität ergibt; im vorliegenden Falle sind dies 6 x 450 nm. In der Praxis beträgt die Ätztiefe jedoch weniger als 50 % des Maximalwertes.

Die erzielten Strukturbreiten von etwa 100 nm lassen sich durch Optimierung der Schreibparameter noch deutlich verkleinern. Wegen des fehlenden Proximity-Effektes ist bei der STM-bzw. SFM-Lithographie sogar eine höhere Auflösung als bei hochenergetischen Elektronen (50 keV) zu erwarten.

### Beispiel 2

Ein Siliciumwafer wird in einer mit Methan gefüllten PECVD-Anlage (paralleler Plattenreaktor, 3-Zoll-Kathode mit 13,56-MHz-Sender, Anode sechsmal größer) mit amorphem wasserstoffhaltigem Kohlenstoff - mit einem optischen Bandabstand von 0,85 eV - beschichtet (Schichtdicke: 200 nm); Abscheideparameter: -900 V Self-bias-Spannung, 0,1 mbar Methandruck, 3 min Abscheidezeit. Auf diese Schicht wird durch Spin-coating eine 45 nm dicke Schicht eines handelsüblichen elektronenstrahlempfindlichen Resists auf Novolakbasis (AZ 5214E, 1:6 mit Methoxypropylacetat verdünnt) aufgebracht und bei 110°C für 90 s auf einer Heizplatte getrocknet. Die obere Schicht wird dann mittels eines Rasterkraftmikroskops (SFM-Gerät) "belichtet", indem die mit -35 V beaufschlagte Sondenspitze mit einer Geschwindigkeit von 3 µm/s die Probe abrastert und so Linien "schreibt" (Strom: < 100 pA). Danach wird der Wafer bei 130°C für 90 s auf einer Heizplatte ausgeheizt, mit nahem UV-Licht ganzflächig belichtet (20 mJ/cm²) und anschließend 20 s lang in einer handelsüblichen wäßrig-alkalischen Entwicklerlösung (AZ 400K, 1:4 mit Wasser verdünnt) entwickelt. Nachfolgend wird der Wafer 60 s lang mit einer Silylierungslösung behandelt, die aus einer 12 %igen Lösung von Bis-(dimethylamino)-dimethylsilan in einer Mischung aus Methoxypropylacetat und n-Decan (Verhältnis 1:1) besteht. Dabei wächst die Schichtdicke des Resists um 15 nm auf insgesamt 60 nm an. Die auf diese Weise erzeugten Strukturen werden mittels einer Plasmaätzanlage (Typ MIE 720, Fa. MRC) bei einer RF-Leistung von 900 W (45 V Self-bias-Spannung) und einem Sauerstofffluß von 30 sccm (3 µbar) in die amorphe wasserstoffhaltige Kohlenstoffschicht übertragen. Die Ätzzeit beträgt dabei 38 s (inklusive 50 % Überätzung), wobei die Dicke der Photoresistschicht auf 20 nm abnimmt und Linien mit einer Breite der Strukturen von 100 nm entstehen (negatives Bild). Das Aspektverhältnis der Strukturen in der Kohlenstoffschicht beträgt somit 2. Die Resiststruktur wird dann mittels eines CF₄-Plasmas in den Siliciumwafer übertragen, wobei sich die maximal mögliche Ätztiefe aus der Resistschichtdicke und der Ätzselektivität ergibt; im vorliegenden Falle sind dies 6 x 200 nm. In der Praxis beträgt die Ätztiefe jedoch weniger als 50 % des Maximalwertes.

### Beispiel 3 (Vergleichsversuch)

Ein Siliciumwafer wird in einer mit Methan gefüllten PECVD-Anlage (paralleler Plattenreaktor, 3-Zoll-Kathode mit 13,56-MHz-Sender, Anode sechsmal größer) mit amorphem wasserstoffhaltigem Kohlenstoff - mit einem optischen Bandabstand von 1,1 eV - beschichtet (Schichtdicke: 250 nm); Abscheideparameter: -650 V Self-bias-Spannung, 0,15 mbar Methandruck, 4,5 min Abscheidezeit. Auf diese Schicht wird durch Spin-coating eine 45 nm dicke Schicht eines elektronenstrahlempfindlichen Resists entsprechend Beispiel 1 aufgebracht und bei 120°C für 60 s auf einer Heizplatte getrocknet. Bei dem Versuch, die obere Schicht mittels eines Rastertunnelmikroskops (STM-Gerät) entsprechend Beispiel 1 zu "belichten", werden Aufladungseffekte beobachtet, die den maximalen Strom begrenzen. Die Strukturen können deshalb nicht vollständig bis zur a-C:H-Schicht entwickelt werden.

### Beispiel 4

In einer Sputteranlage (Typ Z 550, Fa. Leybold) mit einem drehbaren Sputtertarget (aus Kohlenstoff) wird der Substratteller mit einem mit Aluminium beschichteten Siliciumwafer beschickt, dann wird mit einer Turbopumpe auf einen Druck von 9·10⁻⁷ mbar evakuiert. Zur Reinigung des Substrats (beschichteter Wafer) wird - bei einem Argondurchfluß von 50 sccm bzw. einem Sauerstoffdurchfluß von 5 sccm - ein Druck von 5·10⁻³ mbar eingestellt, und anschließend wird bei einer Hochfrequenzleistung von 300 W für 3 min mit beiden Prozeßgasen gesputtert. Dann wird der Sauerstoffdurchfluß gestoppt und weitere 3 min mit reinem Argon gesputtert. Für den Beschichtungsvorgang wird am Kohlenstofftarget ein Gleichspannungsplasma gezündet (Argondurchfluß: 75 sccm) und - zur Reinigung des Targets - zunächst 3 min bei 500 W blind gesputtert (Druck: 7,1·10⁻³ mbar). Anschließend wird das Sputtertarget über das Substrat gefahren und für 900 s weiter gesputtert; dabei wird eine ca. 250 nm dicke, sehr harte, haftfeste amorphe Kohlenstoffschicht mit ausreichender elektrischer Leitfähigkeit erhalten. Auf diese Schicht wird durch Spin-coating eine 45 nm dicke Schicht eines elektronenstrahlempfindlichen Resists entsprechend Beispiel 1 aufgebracht und bei 120°C für 60 s auf einer Heizplatte getrocknet. Die obere Schicht wird dann mittels eines Rastertunnelmikroskops (STM-Gerät) "belichtet", indem die mit -50 V beaufschlagte Sondenspitze mit einer Geschwindigkeit von 1 µm/s die Probe abrastert und so Linien "schreibt" (Strom: 10 pA). Danach wird das Substrat bei 120°C für 120 s auf einer Heizplatte ausgeheizt und anschließend 60 s lang in einer wäßrigen Entwicklerlösung aus Tetramethylammoniumhydroxid (1,19 %) und 1-Phenylethylamin (0,25 %) entwickelt, wobei 150 nm breite Gräben entsprechend dem Scan-Muster entstehen (positives Bild); der Dunkelabtrag bei der Entwicklung beträgt 5 nm. Nachfolgend wird das Substrat 60 s lang mit einer Silylierungslösung behandelt, die aus einer 4 %igen Lösung von Diaminopropyl-dimethylsiloxan-oligomer in 2-Propanol besteht. Dabei wächst die Schichtdicke des Resists um 40 nm auf insgesamt 80 nm an, und die Grabenbreite nimmt von 150 nm auf 90 nm ab. Die auf diese Weise erzeugten Strukturen werden mittels einer Plasmaatzanlage (Typ MIE 720, Fa. MRC) bei einer RF-Leistung von 900 W (45 V Self-bias-Spannung) und einem Sauerstofffluß von 30 sccm (3 µbar) in die gesputterte amorphe Kohlenstoffschicht übertragen. Die Ätzzeit beträgt dabei 36 s (inklusive 50 % Überätzung), wobei die Dicke der Photoresistschicht auf 30 nm abnimmt und die Grabenbreite der Strukturen auf 100 nm zunimmt. Das Aspektverhältnis der Strukturen in der Kohlenstoffschicht beträgt somit 2,5. Die Resiststruktur wird dann mittels eines CF₄-Plasmas in die Aluminiumschicht übertragen, wobei sich die maximal mögliche Ätztiefe aus der Resistschichtdicke und der Ätzselektivität ergibt; im vorliegenden Falle sind dies 4 x 250 nm. In der Praxis beträgt die Ätztiefe jedoch weniger als 50 % des Maximalwertes.

### Beispiel 5

Ein Siliciumwafer wird in einer mit Methan gefüllten PECVD-Anlage (paralleler Plattenreaktor, 3-Zoll-Kathode mit 13,56-MHz-Sender, Anode sechsmal größer) mit amorphem wasserstoffhaltigem Kohlenstoff - mit einem optischen Bandabstand von 0,85 eV - beschichtet (Schichtdicke: 350 nm); Abscheideparameter: -900 V Self-bias-Spannung, 0,1 mbar Methandruck, 7 min Abscheidezeit. Auf diese Schicht wird durch Spin-coating eine 45 nm dicke Schicht eines elektronenstrahlempfindlichen Resists entsprechend Beispiel 1 aufgebracht und bei 120°C für 60 s auf einer Heizplatte getrocknet. Die obere Schicht wird dann mittels eines Rastertunnelmikroskops (STM-Gerät) "belichtet", indem die mit -55 V beaufschlagte Sondenspitze mit einer Geschwindigkeit von 1 µm/s die Probe abrastert und so Linien "schreibt" (Strom: 20 pA). Danach wird der Wafer bei 120°C für 120 s auf einer Heizplatte ausgeheizt und anschließend 60 s lang mit einer Silylierungslösung behandelt, die aus einer 1 %igen Lösung von Diaminopropyl-dimethylsiloxan-oligomer in einer Mischung aus 2-Propanol und Wasser (Verhältnis 15,5:1) besteht. Dabei wächst die Schichtdicke des Resists an den "belichteten" Stellen um 40 nm auf insgesamt 80 nm an. Die auf diese Weise erzeugten Strukturen werden mittels einer Plasmaätzanlage (Typ MIE 720, Fa. MRC) bei einer RF-Leistung von 900 W (45 V Self-bias-Spannung) und einem Sauerstofffluß von 30 sccm (3 µbar) in die amorphe wasserstoffhaltige Kohlenstoffschicht übertragen. Die Ätzzeit beträgt dabei 74 s (inklusive 50 % Überätzung), wobei die Dicke der Photoresistschicht auf 45 nm abnimmt und Strukturen mit einer Linienbreite von 80 nm entstehen (negatives Bild). Das Aspektverhältnis der Strukturen in der Kohlenstoffschicht beträgt somit 4,3. Die Resiststruktur wird dann mittels eines CF₄-Plasmas in den Siliciumwafer übertragen, wobei sich die maximal mögliche Ätztiefe aus der Resistschichtdicke und der Ätzselektivität ergibt; im vorliegenden Falle sind dies 6 x 350 nm. In der Praxis beträgt die Ätztiefe jedoch weniger als 50 % des Maximalwerte-s.

## Patentansprüche

1. Verfahren zur photolithographischen Erzeugung von Strukturen im Sub-200-nm-Bereich, **dadurch gekennzeichnet**, daß auf ein Substrat eine Schicht aus amorphem wasserstoffhaltigem Kohlenstoff (a-C:H) mit einem optischen Bandabstand < 1 eV oder eine Schicht aus gesputtertem amorphem Kohlenstoff (a-C) mit einer Schichtdicke ≤ 500 nm als Bottomresist aufgebracht wird, daß der Bottomresist mit einer Schicht eines elektronenstrahlempfindlichen, siliciumhaltigen oder silylierbaren Photoresists mit einer Schichtdicke ≤ 50 nm als Topresist versehen wird, daß der Topresist mittels Rastertunnelmikroskopie oder Rasterkraftmikroskopie mit Elektronen einer Energie von ≤ 80 eV strukturiert wird, und daß die Struktur durch Ätzen mit einem anisotropen Sauerstoffplasma in den Bottomresist und nachfolgend durch Plasmaätzen in das Substrat übertragen wird.

2. Verfahren nach Anspruch 1, **dadurch gekennzeichnet**, daß die Strukturierung mit einer Strahlendosis im Bereich von 1 bis 50 mC/cm² erfolgt, insbesondere von 10 bis 30 mC/cm².

3. Verfahren nach Anspruch 1 oder 2, **dadurch gekennzeichnet**, daß die Struktur durch Ätzen mit einem Halogenplasma in das Substrat übertragen wird.

4. Verfahren nach einem der Ansprüche 1 bis 3, **dadurch gekennzeichnet**, daß als Substrat ein in der Halbleitertechnik übliches Material verwendet wird.

5. Verfahren nach einem oder mehreren der Ansprüche 1 bis 4, **dadurch gekennzeichnet**, daß der Topresist nach der Strukturierung mit einem siliciumhaltigen Agens behandelt wird.

## Claims

1. Process for photolithographic generation of structures in the sub-200 nm range, characterised in that a layer of amorphous hydrogen-containing carbon (a-C:H) with an optical energy gap of < 1 eV or a layer of sputtered amorphous carbon (a-C) is applied as a bottom resist with a layer thickness of ≤ 500 nm to a substrate, the bottom resist is provided with a layer of an electron beam-sensitive silicon-containing or silylatable photoresist with a layer thickness of ≤ 50 nm as a top resist, the top resist is structured by means of scanning tunnelling microscopy or scanning force microscopy with electrons of an energy of ≤ 80 eV, and the structure is transferred to the bottom resist by etching with an anisotropic oxygen plasma and then to the substrate by plasma etching.

2. Process according to claim 1, characterised in that the structuring is performed with a radiation dose in the range of 1-50 mC/cm², in particular 10-30 mC/cm².

3. Process according to claim 1 or claim 2, characterised in that the structure is transferred to the substrate by etching with a halogen plasma.

4. Process according to one of claims 1 to 3, characterised in that a conventional material in semiconductor technology is used as the substrate.

5. Process according to one or more of claims 1 to 4, characterised in that the top resist is treated with a silicon-containing agent after structuring.

## Revendications

1. Procédé de production photolithographique de structures dans le domaine sub-200-nm, caractérisé en ce qu'on dépose sur un substrat en tant que résist inférieur une couche de carbone amorphe hydrogéné (a-C:H) ayant un intervalle de bande optique < 1eV, ou une couche de carbone amorphe projeté par pulvérisation (a-C) ayant une épaisseur de couche ≤ 500 nm, en ce que le résist inférieur est pourvu d'une couche d'un photorésist sensible aux faisceaux d'électrons, contenant du silicium ou susceptible de silylation ayant une épaisseur de couche ≤ 50 nm, en tant que résist supérieur, en ce qu'on structure le résist supérieur par microscopie à balayage à effet tunnel ou par microscopie à balayage à force avec des électrons d'une énergie de ≤ 80 eV, et en ce que la structure est transférée au résist inférieur par gravure au moyen d'un plasma d'oxygène anisotrope, et ensuite au substrat par gravure au plasma.

2. Procédé selon la revendication 1, caractérisé en ce que la structuration s'effectue avec une dose d'exposition dans l'intervalle de 1 à 50 mC/cm², en particulier de 10 à 30 mC/cm².

3. Procédé selon la revendication 1 ou 2, caractérisé en ce que la structure est transférée au substrat par gravure au moyen d'un plasma d'halogène.

4. Procédé selon une des revendications 1 à 3, caractérisé en ce qu'on utilise comme substrat une matière habituelle dans la technique des semi-conducteurs.

5. Procédé selon une ou plusieurs des revendications 1 à 4, caractérisé en ce que le résist supérieur est traité avec un agent contenant du silicium après la structuration.
